**Europäisches Patentamt**

**European Patent Office**

**Office européen des brevets**

(19)

(11) Veröffentlichungsnummer: **0 245 747**

**A2**

(12) # EUROPÄISCHE PATENTANMELDUNG

(21) Anmeldenummer: **87106450.7**

(22) Anmeldetag: **05.05.87**

(51) Int. Cl.⁴: **H01L 25/12**

(30) Priorität: **10.05.86 DE 3615782**

(43) Veröffentlichungstag der Anmeldung:
**19.11.87 Patentblatt 87/47**

(84) Benannte Vertragsstaaten:
**DE FR GB**

(71) Anmelder: **BROWN, BOVERI & CIE**
**Aktiengesellschaft**
**Kallstadter Strasse 1**
**D-6800 Mannheim 31(DE)**

(72) Erfinder: **Bertsch, Bruno, Dipl.-Ing.**
**Siedlerstrasse 63**
**D-6830 Schwetzingen(DE)**
Erfinder: **Ebert, Reinhold, Dipl,-Ing.**
**Weinbergerstrasse 6a**
**D-6100 Darmstadt(DE)**

(74) Vertreter: **Rupprecht, Klaus, Dipl.-Ing. et al**
**c/o BROWN, BOVERI & CIE AG Postfach 10**
**03 51 Zentralbereich Patente**
**D-6800 Mannheim 1(DE)**

(54) **Anordnung zur Ansteuerung einer Vielzahl parallelgeschalteter Leistungs-Feldeffekttransisitoren.**

(57) Diese Anordnung dient zur exakt symmetrischen Ansteuerung einer Vielzahl von parallelgeschalteten, im Schaltbetrieb arbeitenden Leistungs-Feldeffekttranssistoren (T1...T30). Hierzu sind die Transistoren auf einer Aufbauplatine (6) von länglicher Form derart angeordnet, daß zwei sich gegenüberliegende Reihen gebildet werden. Räumlich benachbarte Transistoren sind jeweils zu einer Gruppe zusammengefaßt. Zu jeder Gruppe führen zwei Sammel-Ansteuerleitungen (4a-e und 5a-e), die über zentrale Sammel-Anschlüsse (22a-e, 23a-e) auf der Aufbauplatine (6) und jeweils gleichlange Leiterbahnen (24,25) mit den einzelnen Transistoren verbunden sind. Auf diese Weise ergibt sich eine "sternförmige" Ansteuerung der einzelnen Transistoren jeder Gruppe, d.h. eine Ansteuerung mit gleichlangen Ansteuerwegen. Die Sammel-Ansteuerleitungen (4a, 5a-e) sind ebenfalls von gleicher Länge, und jeweils zentral miteinander verbunden. Die Aufbauplatine (6) kann mit Bauteilen (7) zur Einzelbeschaltung der Transistoren bestückt sein. Die Lastanschlüsse erfolgen über eine mit der Aufbauplatine (6) verlötete U-förmige Stromschiene (1) und über einen mit den Transistoren kontaktierten Kühlkörper (9). Anwendungsgebiete liegen in der Leistungselektronik, z.B. bei Gleichstromstellern für Maschinen mit hohem Strombedarf.

Fig. 6

## Anordnung zur Ansteuerung einer Vielzahl parallelgeschalteter Leistungs-Feldeffekttransistoren

Die Erfindung bezieht sich auf eine Anordnung zur Ansteuerung einer Vielzahl parallelgeschalteter Leistungs-Feldeffekttransistoren gemäß dem Oberbegriff des Anspruches 1.

In der Leistungselektronik werden vielfach MOS-FET-Leistungstransistoren zur geregelten Strom-bzw. Spannungsversorgung von Motoren eingesetzt. Ein Gleichstrommotor kann z.B. über einen mit MOS-FET bestückten Vierquadrantensteller in beiden Drehrichtungen mit unterschiedlichen Drehzahlen aus einer Gleichspannungsquelle betrieben werden. Feldeffekttransistoren haben insbesondere im Teillastbereich ein günstigeres Verhalten hinsichtlich Verlustleistung und erforderlicher Ansteuerleistung als bipolare Transistoren. Schwierigkeiten ergeben sich jedoch, wenn verhältnismäßig hohe Ströme zu schalten sind, da die verfügbaren Leistungs-MOS-FET nur für relativ niedrige Ströme geeignet sind. Durch Parallelschaltung einer Vielzahl von Leistungs-Feldeffekttransistoren mit gemeinsamer und gleichzeitiger Ansteuerung kann Abhilfe geschaffen werden. Dabei ist jedoch zu beachten, daß alle parallelen Feldeffekttransistoren exakt symmetrisch anzusteuern sind, um eine thermische Überlastung einzelner Transistoren mit nachfolgender Zerstörung zu vermeiden.

Der Erfindung liegt die Aufgabe zugrunde, eine Anordnung zur Ansteuerung einer Vielzahl parallelgeschalteter Leistungs-Feldeffekttransistoren der eingangs genannten Art anzugeben, die eine exakt symmetrische Ansteuerung aller parallelen Transistoren gewährleistet.

Diese Aufgabe wird in Verbindung mit den Merkmalen des Oberbegriffes erfindungsgemäß durch die im Kennzeichen des Anspruches 1 angegebenen Merkmale gelöst.

Die mit der Erfindung erzielbaren Vorteile bestehen insbesondere darin, daß die angegebene Anordnung eine sehr präzise, gleichzeitige Ansteuerung aller parallelgeschalteten Feldeffekttransistoren ermöglicht. Aufgrund der Unterteilung der Transistoren in einzelne Gruppen ist eine "sternförmige" Ansteuerung der einzelnen Transistoren jeder Gruppe gewährleistet, d.h., eine Ansteuerung mit gleichlangen Ansteuerwegen. Die einzelnen Gruppen wiederum werden "sternförmig" über gleichlange Sammelleitungen angesteuert, so daß eine exakt symmetrische Ansteuerung aller parallelen Transistoren erzielt wird. Die Anordnung ist vorteilhaft kompakt aufgebaut und besitzt kurze Leitungen sowohl im Ansteuerteil als auch im Lastteil. Weitere Vorteile sind aus der nachstehenden Beschreibung ersichtlich.

Vorteilhafte Ausgestaltungen der Erfindung sind in den Unteransprüchen gekennzeichnet.

Die Erfindung wird nachstehend anhand der in den Zeichnungen dargestellter Ausführungsbeispiele erläutert.

Es zeigen:

Fig. 1 Eine Aufsicht auf einen Brückenzweig eines Vierquadrantenstellers,

Fig. 2 eine Seitenansicht auf die Längsseite eines Bruckenzweiges,

Fig. 3 eine Seitenansicht auf die Schmalseite eines Brückenzweiges,

Fig. 4 eine Seitenansicht auf die Längsseite einer Halbbrücke,

Fig. 5 eine Seitenansicht auf die Schmalseite einer Halbbrücke,

Fig. 6 eine Aufsicht auf eine Aufbauplatine für Transistoren und Einzelbeschaltung,

Fig. 7 die Anordnung der beiden Brückenzweige einer Halbbrücke.

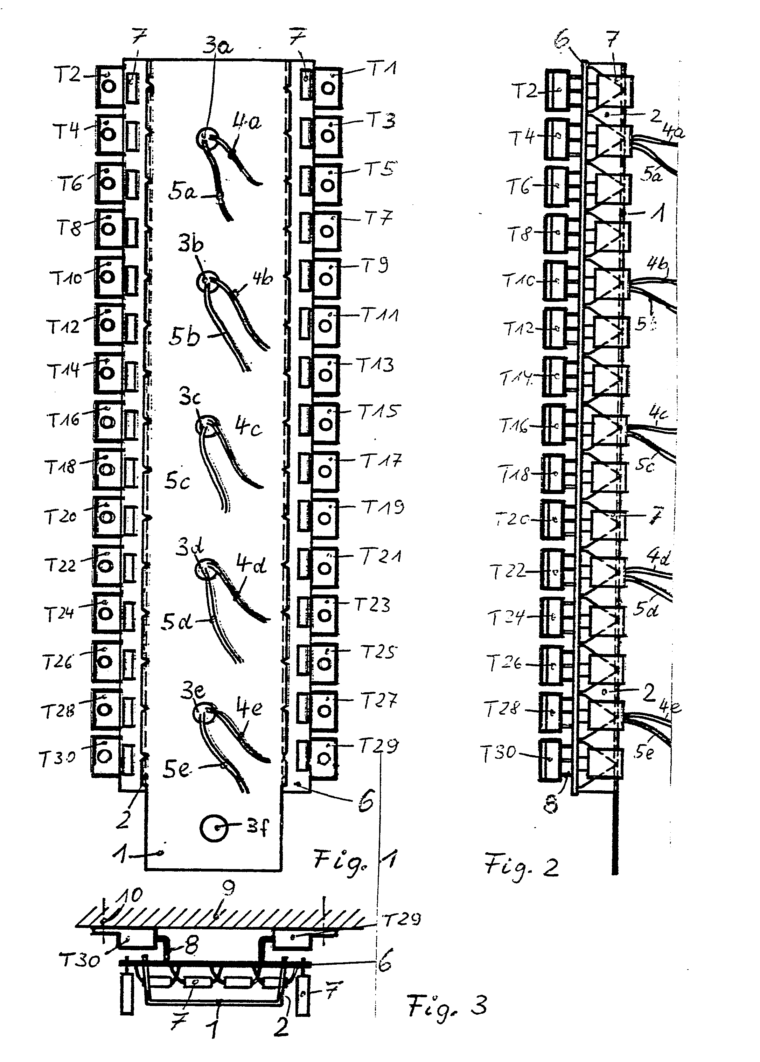

In Figur 1 ist eine Aufsicht auf einen Brückenzweig eines Vierquadrantenstellers dargestellt. Der Brückenzweig weist beispielsweise 30 parallelgeschaltete MOS-FET-Leistungstransistoren T1, T2 ... T30 auf, die gemeinsam und gleichzeitig jeweils zwischen Gate G und Source S anzusteuern sind. Die Transistoren sind in zwei sich gegenüberliegenden Reihen zu jeweils 15 Stück aufgeteilt. Zur gemeinsamen leistungsmäßigen Verbindung aller Source-Anschlüsse S der Leistungstransistoren T1 ... T30 ist eine länglich ausgebildete, U-förmig gebogene Stromschiene 1 aus Kupfer vorgesehen. Zur Bildung von Source-Anschlußpunkten für die Transistoren sind die beiden abgebogenen Seitenteile der Stromschiene 1 dreieckförmig ausgestanzt, so daß sich auf jeder Seite mindestens 15 dreieckförmige Befestigungsecken 2 für die Source-Lastanschlüsse der 30 Leistungstransistoren T1 ... T30 ergeben.

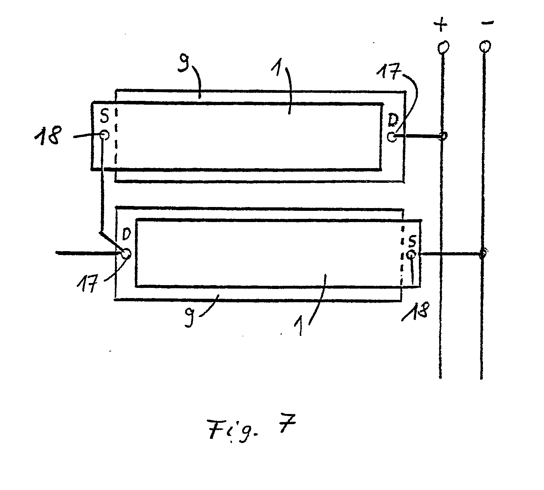

Zur Schaffung symmetrischer Ansteuerverhältnisse für alle parallelgeschalteten Transistoren sind die 30 MOS-FET-Leistungstransistoren T1 ... T30 in 5 Gruppen zu je 6 Transistoren zusammengefaßt. Die Transistoren T1 ... T6, T7 ... T12, T13 ...T18, T19 ... T24 und T25 ... T30 bilden dabei jeweils eine Gruppe. Jede Gruppe besitzt zwei sich gegenüberliegende Reihen zu jeweils 3 Transistoren. Zentral in Bezug zu jeder Gruppe ist das Mittelteil der Stromschiene 1 mit Mittelbohrungen 3a,b, c,d,e versehen, wobei die Mittelbohrung 3a zu Gruppe T1 ...T6, die Mittelbohrung 3b zu Gruppe T7 ... T12 usw. zugehörig ist. Eine weitere Bohrung 3f im verlängerten Endteil der Stromschiene 1 dient zur Bildung eines gemeinsamen Source-Lastanschlusses. Durch jede Mittelbohrung 3a-e sind jeweils zwei Ansteuerleitungen geführt, und zwar je eine Sammel-Gate-Anschlußleitung 4a-e und eine Sammel-Source-Anschlußleitung 5a-e. Die weitere Verschaltung dieser Ansteuerleitungen ist unter Figur 6 beschrieben.

Zur Verschaltung der Transistoranschlüsse und zum Aufbau der Einzelbeschaltung für die Transistoren ist eine Aufbauplatine 6 vorgesehen. Die in Fig. 1 teilweise von der Stromschiene 1 verdeckte Aufbauplatine 6 ist beidseitig mit Leiterbahnen beschichtet und trägt auf ihrer Oberseite Bauteile 7 der Einzelbeschaltung, insbesondere Widerstände und Kondensatoren zur du/dt-Begrenzung und Gate-Widerstände zur Unterdrückung von Schwingungen zwischen den Gate-Anschlüssen der parallel geschalteten Transistoren.

In Figur 2 ist eine Seitenansicht auf die Längsseite eines Brückenzweiges dargestellt. Es ist die Stromschiene 1 mit den dreieckförmigen Befestigungsecken 2 im abgebogenen Seitenteil zu erkennen. Die Anschlußdrähte 8 der Leistungstransistoren (es sind die Transistoren T2,T4, T6 ...T30 dargestellt) sind auf der Aufbauplatine 6 verlötet. Einzelne Bauteile 7 der Aufbauplatine 6 sind gezeigt. Desweiteren ist die Zuordnung je einer Sammel-Gate-Anschlußleitung 4a-e und je einer Sammel-Source-Anschlußleitung 5a-e je einer der 5 Transistor-Gruppen zu erkennen.

In Figur 3 ist eine Seitenansicht auf die Schmalseite eines Brückenzweiges dargestellt. Es ist die Stromschine 1 mir ihrem parallel zur Aufbauplatine 6 liegenden Mittelteil und den beiden U-förmig abgebogenen Seitenteilen zu erkennen. Die Befestigungsecken 2 der Stromschiene 1 sind mit der Aufbauplatine 6 verlötet, ebenso wie die Anschlußdrähte 8 der Transistoren (es sind die beiden sich gegenüberliegenden Transistoren T29, T30 dargestellt). Ferner sind einzelne Bauteile der Aufbauplatine 6 zu erkennen. Die Transistoren selbst liegen mit ihren Kühlblechen an einem allen Transistoren des Brückenzweiges gemeinsamen Kühlkörper 9, wobei die Befestigung der einzelnen Transistoren mittels Montageschrauben 10 erfolgt. Der Kühlkörper 9 wird zur Bildung des gemeinsamen Drain-Lastanschlusses der Transistoren herangezogen.

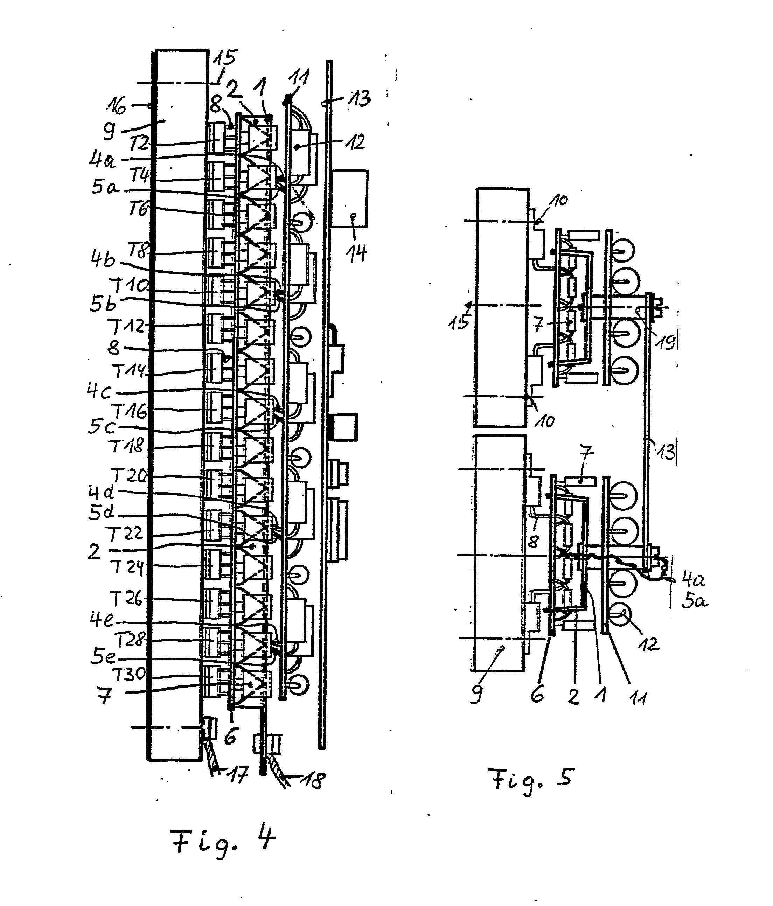

In Figur 4 ist eine Seitenansicht auf die Längsseite einer aus zwei Brückenzweigen bestehenden Halbbrücke dargestellt. Es sind die kupferne Stromschiene 1 mit den Befestigungsecken 2, die Sammel-Gate-Anschlußleitungen 4a-e, die Sammel-Source-Anschlußleitungen 5a-e, die Aufbauplatine 6 für die Transistoren und die Einzelbeschaltung, die Bauteile 7 der Aufbauplatine 6, die Transistoren mit ihren Anschlußdrähten 8 und der Kühlkörper 9 für einen Brückenzweig zu erkennen. In der Ebene über der Stromschiene 1 befindet sich eine Aufbauplatine 11 für die Gruppenbeschaltung der Transistoren (es sind die Transistoren T2, T4...T30 dargestellt). Die Bauteile 12 (Widerstände, Kondensatoren, Dioden) der Gruppenbeschal tung dienen jeweils zur Beschaltung einer aus je 6 Transistoren bestehenden Gruppe (Transistor-Gruppen T1 ... T6, T7 ... T12 usw.). Die Beschaltung dient zur Begrenzung der Abschalt-Spannungsspitzen. In der Ebene über der Aufbauplatine 11 für die Gruppenbeschaltung befindet sich eine Aufbauplatine 13 für die Aussteuerung mit Bauteilen 14 zur Realisierung von Ansteuer-und Regeleinrichtungen für die Transistoren des Vierquadrantenstellers.

Der Kühlkörper 9 kann mit Hilfe von Montagschrauben auf einem weiteren, übergeordneten und verrippten Kühlkörper befestigt werden, wobei sich zur Isolierung gegen das Drain-Potential des Kühlkörpers 9 eine Kunststoffolie 16 zwischen Kühlkörper 9 und dem übergeordneten Kühlkörper befindet. Der Kühlkörper 9 ist mit einem Drain-Lastanschluß 17 und die Stromschiene 1 mit einem Source-Lastanschluß 18 (siehe auch Bohrung 3f in Fig. 1) versehen.

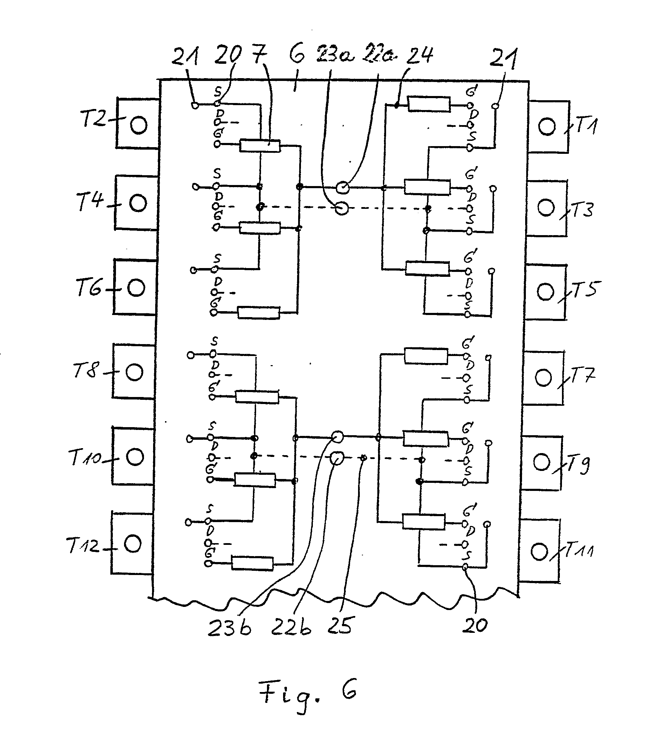

In Figur 5 ist eine Seitenansicht auf die Schmalseite einer Halbbrücke dargestellt, wobei die beiden Brückenzweige zu erkennen sind. Es sind die Stromschienen 1 mit den auf den Aufbauplatinen 6 verlöteten Befestigungsekken 2, die Sammel-Gate-Anschlußleitungen 4a, die Sammel-Source-Anschlußleitungen 5a, die Bauteile 7 der Platinen 6, die Platinen 11 für Guppenbeschaltung mit Bauteilen 12, die beiden Brückenzweigen gemeinsame Platine 13 für die Aussteuerung, die beiden getrennten Kühlkörper 9 sowie die darauf montierten Transistoren zu erkennen. Zur mechanischen Verbindung zwischen Stromschiene 1, Aufbauplatine 11 für Gruppenbeschaltung und Aufbauplatine 13 für Ansteuerung sind Bolzen 19 vorgesehen. Die Sammel-Gate-Anschlußleitungen 4a-e und die Sammel-Source-Anschlußleitungen 5a-e sind jeweils aus Gründen der exakten symmetrischen Ansteuerung aller parallelgeschalteten Transistoren gleichlang und miteinander verdrillt.

In Figur 6 ist eine Aufsicht auf eine Aufbauplatine 6 für Transistoren und Einzelbeschaltung dargestellt. Es sind zwei Transistor-Gruppen, und zwar eine erste Gruppe mit den Transistoren T1-T6 und eine zweite Gruppe mit den Transistoren T7-T12 zu erkennen. Die Anschlußdrähte 8 der Transistoren werden durch im seitlichen Bereich der Aufbauplatine 6 angeordnete Anschlußbohrungen 20 gesteckt und verlötet. Die Source-Anschlüsse S der Transistoren sind jeweils über kurze Leiterbahnen mit weiteren Anschlußbohrungen 21 für die Befestigungsecken 2 der Stromschiene 1 verbunden. Die Befestigungsecken 2 werden auf diese Anschlußbohrungen 21 aufgesteckt und verlötet. Die Gate-Anschlüsse G aller Transistoren einer Gruppe sind über Leiterbahnen 24 zu einem gemeinsamen Sammel-Gate-Anschluß 22a-e geführt, wobei jeder Anschluß 22a-e mit einer Anschlußleitung 4a-e verlötet ist. Zwischen jedem einzelnen Gate-Anschluß G der Transistoren und dem gemeinsamen Anschluß 22a-e ist je ein Widerstand (zugehörig zu den Bauteilen 7) auf der Aufbauplatine 6 vorgesehen. Die Source-Anschlüsse S aller Transistoren einer Gruppe sind über teilweise auf der Rückseite der beidseitig beschichteten Aufbauplatine 2 befindliche Leiterbahnen 25 zu einem gemeinsamen Sammel-Source-Anschluß 23a-e geführt, wobei jeder Anschluß 23a-e mit je einer Anschlußleitung 5a-e verlötet ist. Die Leiterbahnen 25 können teilweise auch unter den Widerständen durchgeführt sein. Die Drain-Anschlüsse D der Transistoren sind über eigene Leiterbahnen mit Einzel-Beschaltungs-Bauteilen verbunden (aus Gründen der Übersichtlichkeit in Figur 6 nicht dargestellt). Durch die gezeigte und beschriebene geometrische Aufteilung und Zusammenfassung der Vielzahl von parallelen Transistoren zu Gruppen wird eine "sternförmige" Ansteuerung aller MOS-FET-Leistungstransistoren bewirkt, d.h. die Ansteuerwege zu jedem Transistor sind exakt gleichlang und gleichartig ausgebildet.

In Figur 7 ist die Anordnung der beiden Brückenzweige einer Halbbrücke dargestellt. Die Brückenzweige mit Stromschienen 1 und Kühlkörper 3 sind um 180° gegeneinander verdreht untereinander angeordnet. Der Drain-Last-Anschluß 17 (auf Kühlkörper) des 1. Brückenzweiges ist mit der positiven Spannungsversorgungs-Stromschiene verbunden. Der Source-Lastanschluß 18 (auf Stromschiene) des 1. Brückenzweiges ist an den Drain-Lastanschluß 17 des 2. Brückenzweiges angeschlossen. Der Source-Lastanschluß 18 des 2. Brückenzweiges liegt an der negativen Spannungsversorgungs-Stromschiene. Die Last ist an den Drain-Lastanschluß 18 des 2. Brückenzweiges angeschlossen. Aufgrund dieses Aufbaus ergeben sich kurze Verbindungsleitungen und dadurch vorteilhaft kleine Leitungsinduktivitäten.

## Ansprüche

1. Anordnung zur Ansteuerung einer Vielzahl parallelgeschalteter, im Schaltbetrieb arbeitender Leistungs-Feldeffekttransistoren, gekennzeichnet durch folgende Merkmale
- die Transistoren (T1...T30) sind auf einer ersten Aufbauplatine (6) von länglicher Form derart angeordnet, daß zwei sich gegenüberliegende Reihen gebildet werden,
- räumlich benachbarte Transistoren (T1... T6, T7 ...T12 usw.) sind jeweils zu einer Gruppe zusammengefaßt,
- zu jeder Gruppe führen zwei Sammel-Ansteuerleitungen (4a-e, 5a-e), die über zentrale Sammel-Anschlüsse (22a-e, 23a-e) auf der ersten Aufbauplatine (6) und jeweils gleichlange Leiterbahnen (24,25) mit den einzelnen Transistoren (T1... T6, T7 ...T12 usw.) verbunden sind,
- die Sammel-Ansteuerleitungen (4a-e, 5a-e) sind von gleicher Länge und jeweils zentral miteinander verbunden.

2. Anordnung nach Anspruch 1, dadurch gekennzeichnet, daß zur Bildung von Lastanschlüssen für die Transistoren (T1...T30) eine U-förmig gebogene Stromschiene (1) vorgesehen ist, die über seitliche Befestigungsecken (2) jeweils mit Anschlußbohrungen (21) in der ersten Aufbauplatine (6) verlötet ist.

3. Anordnung nach Anspruch 2, dadurch gekennzeichnet, daß die Stromschiene (1) mit Mittelbohrungen (3a-e) zur Durchführung der Sammel-Ansteuerleitungen (4a-e, 5a-e) jeder Gruppe versehen ist.

4. Anordnung nach den Ansprüchen 1 bis 3, dadurch gekennzeichnet, daß Bauteile (7) für die Einzelbeschaltung der Transistoren (T1...T30) direkt auf der ersten Aufbauplatine (6) vorgesehen sind.

5. Anordnung nach den Ansprüchen 2 bis 4, dadurch gekennzeichnet, daß eine zweite Aufbauplatine (11) mit Bauteilen (12) für die Gruppenbeschaltung der Transistoren (T1...T30) über der Stromschiene (1) angeordnet ist.

6. Anordnung nach Anspruch 5, dadurch gekennzeichnet, daß eine dritte Aufbauplatine (13) mit Bauteilen (14) für die Aussteuerung über der zweiten Aufbauplatine (11) vorgesehen ist.

Fig. 1

Fig. 2

Fig. 3

Fig. 4

Fig. 5

Fig. 6

Fig. 7